# EUROPEAN PATENT APPLICATION

(11) **EP 4 358 130 A1**
(43) Date of publication of application: **24.04.2024**
(21) Application number: 22203103.1
(22) Date of filing: 21.10.2022
(51) Int. Cl.: H01L 23/473, H02M 7/00

(54) **HEAT SINK**

(71) Applicant: Universität der Bundeswehr München, 85579 Neubiberg (DE)
(72) Inventor: Cömert, Arif Sefa, 80933 München (DE)
(74) Representative: Lucke, Andreas

(57) **Abstract**

A heat sink comprises first coolant channels and second coolant channels. The first coolant channels comprise first inflow sections and are adapted to guide first coolant flows. The second coolant channels comprise second inflow sections and are adapted to guide second coolant flows. The heat sink comprises a first distribution section, providing a fluid connection between the first inflow sections, a second distribution section, providing a fluid connection between the second inflow sections, and a common outflow section for the first coolant flows and the second coolant flows. The heat sink comprises transverse channels between the first coolant channels and the second coolant channels to guide at least a portion of the second coolant flows into the first coolant flows.

## Description

### TECHNICAL FIELD

The disclosure relates to a heat sink, more specifically to a heat sink with internal channels for a coolant fluid such as water, for example for cooling power electronics or optoelectronic devices.

### BACKGROUND

In high-power electronics such as inverters for electric mobility, wind or solar power plants, electronic components like transistors produce waste heat at a density of 100 W/cm² and more. Similar power densities occur in high-power optoelectronic devices such as high-power solid-state/diode lasers or in concentrator solar cells, or in computing devices such as processors.

The waste heat increases the temperature of the respective component, e. g. of the transistor or of the laser diode. The increase in temperature deteriorates the performance of the component and may even lead to its destruction, if excessive. Therefore, a heat sink is commonly applied in thermal contact with the respective component, to cool it and to limit its temperature increase.

Conventional heat sinks use their external surface(s) to transfer the waste heat from the component via said external surface(s) to the ambient, typically to surrounding air. This process may be enhanced with a fan to drive a convective flow of heat away from the external surface(s).

Even faster transport of the waste heat may be achieved using a heat sink with internal channels for a coolant fluid such as water. A corresponding heat sink may be connected to a pump, which drives a flow of the coolant fluid through the channels. The heat sink transports the waste heat from the component to its internal channels. The waste heat is transferred to the coolant fluid in the channels, and, with the flow of the coolant fluid, away from the heat sink.

The efficiency of the transfer of the waste heat depends on the arrangement of the channels. Moreover, this arrangement determines, how homogeneously the heat sink and/or the component(s) in thermal contact therewith are cooled. Moreover, the arrangement of the channels determines their flow resist to the flow of the coolant fluid, and thus the power consumption of the cooling, e. g. as an electrical power to continuously operate the pump.

### OVERVIEW

In view of the technical problems laid out above, there is a need for an improved heat sink with channels and operation thereof. This objective is achieved with a heat sink according to claim 1 and a method according to claim 14.

In a first aspect, a heat sink comprises first coolant channels and second coolant channels. The first coolant channels comprise first inflow sections and are adapted to guide first coolant flows. The second coolant channels comprise second inflow sections and are adapted to guide second coolant flows. The heat sink comprises a first distribution section, providing a fluid connection between the first inflow sections, a second distribution section, providing a fluid connection between the second inflow sections, and a common outflow section for the first coolant flows and the second coolant flows. The heat sink comprises transverse channels between the first coolant channels and the second coolant channels to guide at least a portion of the second coolant flows into the first coolant flows.

The inventor has realized that in a heat sink with channels, a thermal resistance layer tends to form along the inner faces of the channels. The thermal resistance layer is related to the velocity profile of the coolant within the channel, with the smallest velocity closest to the inner face of the channel. This small velocity limits the flow of the coolant along the inner faces of the channel, resulting in a higher temperature of the coolant there. The transfer of waste heat from the heat sink into the coolant in the channels depends on the temperature difference between the (hot) channel walls and the coolant and is reduced. In other words, the (longitudinally) slowly flowing coolant at the inner faces of the channels forms the thermal resistance layer.

To solve this problem, the heat sink according to the disclosure comprises two types of (i. e., first and second) coolant channels, and transverse channels to guide a flow from one type into the other. The transverse channels guide a flow through them, i.e. a flow transverse to the coolant channels. The flow through the transverse channels breaks up the thermal resistance layer at the inner faces of the first and second coolant channels and therefore improves the heat transport. To ensure that the flow is induced through the transverse channels along the desired direction (i. e., from the second coolant channels into the first coolant channels), the channels of the respective type are fluid-supplied from respective distribution sections. The distribution sections for the first/second channels may be supplied with suitable relative coolant flow rates or suitable (e. g., different) coolant pressures to ensure the direction of the transverse flow from the second coolant channels into the first coolant channels.

The heat sink may comprise an alternating arrangement of the first coolant channels and the second coolant channels. Alternatively, or in addition, the heat sink may comprise common channel walls of the first coolant channels and the second coolant channels.

Corresponding embodiments may provide an enhanced flow through the transverse channels, and efficient breaking up of the thermal resistance layer.

The transverse channels may be formed along at least 30 % or along at least 50 % or along at least 70 % of a length extension of the first coolant channels and/or of a length extension of the second coolant channels and/or of a length extension of the common channel walls.

The transverse channels maybe formed at each boundary (e. g., in each common channel wall) of the first coolant channels and the second coolant channels.

For example, the arrangement of the first coolant channels and the second coolant channels may be alternating along a direction perpendicular to main directions of the first coolant flows and/or to main directions of the second coolant flows. The transverse channels may be formed at an angle of up to 45° with respect to the directions of the second channels or with respect to the main directions of the first coolant flows and/or of the second coolant flows.

The common channel walls may separate sections of the first coolant channels from sections of the second coolant channels. In other words, the first coolant channels may be separated from the second coolant channels by the common channel walls.

The common channel walls may comprise the transverse channels.

Directions of the first coolant channels may be parallel to each other. Alternatively, or in addition, directions of the second coolant channels maybe parallel to each other. Alternatively, or in addition, directions of the first coolant channels may be parallel to directions of the second coolant channels. Alternatively, or in addition, a reference plane perpendicular to at least one of the first coolant channels or perpendicular to at least one of the second coolant channels may intersect the first coolant channels and the second coolant channels.

Corresponding embodiments may provide a particularly homogeneous cooling of a volume or an area covered by the channels.

The reference plane may be perpendicular to any or all of the first coolant channels. Alternatively, or in addition, the reference plane may be perpendicular to any or all of the second coolant channels.

The second coolant channels may extend in parallel to the first coolant channels, for example along at least half of their respective lengths or along at least 80% of their respective lengths or along their entire respective lengths.

The directions of the first (or second) coolant channels may refer to directions, along which the first (or second) coolant channels extend, and/or to main flow directions of the first (or second) coolant flows.

The first coolant channels and/or the second coolant channels may be arranged along a second reference plane, wherein the second reference plane comprises a direction of at least one the first coolant channels and/or of at least of one of the second coolant channels. In other words, the second reference plane may intersect the first coolant channels and/or the second coolant channels, i. e. any of the respective coolant channels, and maybe arranged along at least one of the first coolant channels and/or of the second coolant channels.

The first coolant channels may be at least three first coolant channels or at least four first coolant channels.

The second coolant channels may be at least three second coolant channels or at least four second coolant channels.

Lengths of the first coolant channels and/or lengths of the second coolant channels may be at least 30 mm or at least 40 mm or at least 80 mm, respectively.

The coolant may be a fluid, such as air or water or a mixture of water and glycol, for example with a ratio of 1:1. The coolant channels may be fluid-tight for the coolant.

The heat sink may further comprise a heat sink body.

The heat sink body may comprise the first coolant channels and/or the second coolant channels. In other words, the first coolant channels and/or the second coolant channels may be internal to the heat sink, in particular to the heat sink body.

The heat sink body may comprise the first inflow sections and/or the second inflow sections.

The heat sink body may comprise the first distribution section and/or the second distribution section and/or the common outflow section.

The heat sink may further comprise a first coolant inlet and a first fluid connection between the first coolant inlet and the first distribution section to supply the first coolant flows to the first coolant channels. The heat sink may further comprise a second coolant inlet and a second fluid connection between the second coolant inlet and the second distribution section to supply the second coolant flows to the second coolant channels. In embodiments comprising a/the heat sink body, the first coolant inlet and the second coolant inlet may be arranged spaced apart from each other on the heat sink body, e. g. on an external surface of the heat sink body.

The first coolant inlet may be in direct contact with the first distribution section.

The second coolant inlet may be in direct contact with the second distribution section.

The first coolant inlet and/or the first fluid connection may be separated from the second coolant inlet and/or from the second fluid connection, for example in a fluid-tight manner.

The first distribution section may be separated from the second distribution section, for example in a fluid-tight manner.

The heat sink may comprise a coolant throughput divider adapted to control the relative coolant throughputs through the first coolant inlet and the second coolant inlet. Alternatively, or in addition, the coolant throughput divider maybe adapted to control the pressure of coolant at the first coolant inlet and at the second coolant inlet.

A heat sink system may comprise a heat sink according to one of the above embodiments and a first pump, wherein the first pump is fluid-connected to the first coolant inlet and adapted to drive the first coolant flows.

The heat sink system may further comprise a second pump, wherein the second pump is fluid-connected to the second coolant inlet and adapted to support the second coolant flows.

Alternatively, the heat sink system may comprise the coolant throughput divider, fluid-connected to the first pump and arranged downstream from the first pump. The coolant throughput divider may be fluid-connected to the first coolant inlet and/or to the second coolant inlet.

The first coolant channels may extend from the first distribution section to the common outflow section.

The second coolant channels may extend from the second distribution section to the common outflow section.

Directions of the transverse channels may be inclined with respect to directions of the second coolant channels. Alternatively, the directions of the transverse channels may be inclined with respect to directions of the second coolant channels at acute angles.

Corresponding arrangements may further help to ensure the flow from the second channels through the transverse channels into the first channels. Thus, the thermal resistance layer gets broken apart reliably.

Widths of the transverse channels may be smaller than widths of the first coolant channels and/or than widths of the second coolant channels.

The transverse channels may be adapted to gradually guide the at least a portion of the second coolant flows into the first coolant flows.

The transverse channels may comprise at least two or at least three or at least four or at least five transverse channels between one of the first coolant channels and a neighboring second coolant channel, in particular between the respective first coolant channel and each of two second coolant channels neighboring the respective first coolant channel. Each of the respective transverse channels may be adapted to guide at least a portion of the respective second coolant flow(s) (i.e., through the respective second coolant channel(s)) into the respective first coolant flow (i.e., through the respective first coolant channel). Any first channel neighbored by a second channel, or any first channel neighbored by two second channels, may be characterized accordingly.

The transverse channels may be adapted to gradually guide the second coolant flows into the first coolant flows, or to gradually guide the entire second coolant flows into the first coolant flows.

For example, widths of the transverse channels may be smaller than widths of the first coolant channels and/or than widths of the second coolant channels at least by a factor of 1.5, or at least by a factor of 2.

The transverse channels between the first coolant channels and the second coolant channels may be adapted to guide the second coolant flows into the first coolant flows, i. e. to guide the entire second coolant flows into the first coolant flows. Alternatively, or in addition, ends of the second coolant channels opposite to the first inflow sections may be closed. Alternatively, or in addition, the second coolant channels, along the directions of the second coolant channels, may be closed at both ends.

The heat sink may further comprise guiding faces in the second coolant channels adapted to guide the at least a portion of the second coolant flows to and/or into the transverse channels.

Corresponding arrangements may further help to ensure the flow from the second channels through the transverse channels into the first coolant channels. Thus, the thermal resistance layer gets broken reliably.

The guiding faces may extend into the second coolant channels, and/or the guiding faces may be inclined with respect to directions of the second coolant channels, or the guiding faces may be inclined with respect to the directions of the second coolant channels at acute angles.

The guiding faces may be inclined with respect to main directions of the second coolant flows, in particular at acute angles.

The heat sink may further comprise protrusions from the inner faces of the second coolant channels, wherein the guiding faces are arranged on the protrusions.

The first coolant channels may provide Reynolds numbers between 3000 and 5000. Alternatively, or in addition, the second coolant channels may provide Reynolds numbers between 3000 and 5000.

The respective Reynolds numbers may refer to Reynolds numbers for the first coolant flows (or for the second coolant flows, respectively) of water or of a mixture of water and glycol, e. g. with a ratio of 1:1, as a coolant.

The respective Reynolds numbers may refer to Reynolds numbers for the first coolant flows (or for the second coolant flows, respectively) at room temperature, e. g at 295 K.

Corresponding embodiments may ensure a turbulent flow in the first and/or second coolant channels, which may further help to break apart the thermal resistance layer.

A total flow resist of the second coolant channels may exceed a total flow resist of the first coolant channels. Alternatively, or in addition, cross-sectional areas of the second coolant channels may decrease as the second coolant channels extend away from the second inflow sections.

Corresponding arrangements may further help to ensure the flow from the second coolant channels through the transverse channels into the first coolant channels. Thus, the thermal resistance layer gets broken reliably.

According to embodiments, transverse channels further away from the second inflow sections comprise cross sectional areas or widths or diameters different from cross sectional areas or widths or diameters of transverse channels closer to the second inflow sections. In other words, the cross-sectional areas, or the widths, or the diameters, respectively, of the transverse channels along the direction of the second coolant channels or along the main direction of the second coolant flows changes as the second coolant channels extend away from the second inflow sections.

The heat sink may further comprise a cooling surface. At least sections of the first coolant channels may extend in parallel to the cooling surface; and/or at least sections of the second coolant channels may extend in parallel to the cooling surface; and/or the heatsink may comprise a heat conducting material arranged between the cooling surface and the first coolant channels and/or the second coolant channels, wherein a thickness of the heat conducting material between the cooling surface and the first coolant channels and/or the second coolant channels is at least 4 mm or at least 6 mm or at least 7 mm or at least 8 mm.

A corresponding arrangement improves the homogeneity of the temperature at the cooling surface.

The first coolant channels and/or the second coolant channels may extend in parallel to the cooling surface along at least half of their respective lengths or along at least 80% of their respective lengths or along their entire respective lengths.

The cooling surface may be arranged on the heat sink body.

The cooling surface may be flat and/or may be adapted to mount a component to be cooled thereon.

The cooling surface may be in thermal contact with the first coolant channels and/or the second coolant channels.

The thickness of the heat conducting material between the cooling surface and the first coolant channels and/or the second coolant channels may be at most 20 mm or at most 15 mm or at most 12 mm.

The heat conducting material may be a metallic material and/or may comprise or may be composed of aluminum or copper.

The heat sink may comprise the cooling surface and a second cooling surface opposite to the cooling surface. For example, the cooling surface and the second cooling surface may be arranged on opposite sides of the heat sink body. The second cooling surface may be characterized by features corresponding to the ones described above in the context of the cooling surface.

A second aspect relates to a method for operating a heat sink. The heat sink comprises first coolant channels and second coolant channels. The first coolant channels comprise first inflow sections and are adapted to guide first coolant flows. The second coolant channels comprise second inflow sections and are adapted to guide second coolant flows. The heat sink further comprises a first distribution section, providing a fluid connection between the first inflow sections, a second distribution section, providing a fluid connection between the second inflow sections, a common outflow section for the first coolant flows and the second coolant flows, and transverse channels between the first coolant channels and the second coolant channels. The method comprises adjusting a first coolant throughput through the first distribution section, and adjusting a second coolant throughput through the second distribution section to guide at least a portion of the second coolant flows through the transverse channels into the first coolant flows.

The method may comprise adjusting the second coolant throughput independently of the first coolant throughput; and/or adjusting a first coolant pressure at the first distribution section to a value different from a second coolant pressure at the second distribution section.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1a: gives a sectional view of a heat sink according to a first embodiment along an x-y-plane;
- Fig. 1b: gives another sectional view of the heat sink according to the first embodiment along another x-y-plane;
- Fig. 2a: gives a sectional view of the heat sink according to the first embodiment along a y-z-plane;
- Fig. 2b: gives another sectional view of the heat sink according to the first embodiment along another y-z-plane;
- Fig. 2c: gives another sectional view of the heat sink according to the first embodiment along another y-z-plane;
- Fig. 3: illustrates the structure of the first coolant channels and the second coolant channels according to an embodiment;
- Fig. 4a: gives a sectional view along an x-y-plane of a heat sink according to another embodiment;
- Fig. 4b: gives another sectional view along another x-y-plane of the heat sink according to the embodiment of Fig. 4a;
- Fig. 5: shows a perspective view of the heat sink according to the embodiment of Fig. 4a;
- Fig. 6a: illustrates a heat sink system according to a first embodiment;
- Fig. 6b: illustrates a heat sink system according to a second embodiment; and
- Fig. 7: illustrates a method according to an embodiment.

### DETAILED DESCRIPTION OF EMBODIMENTS

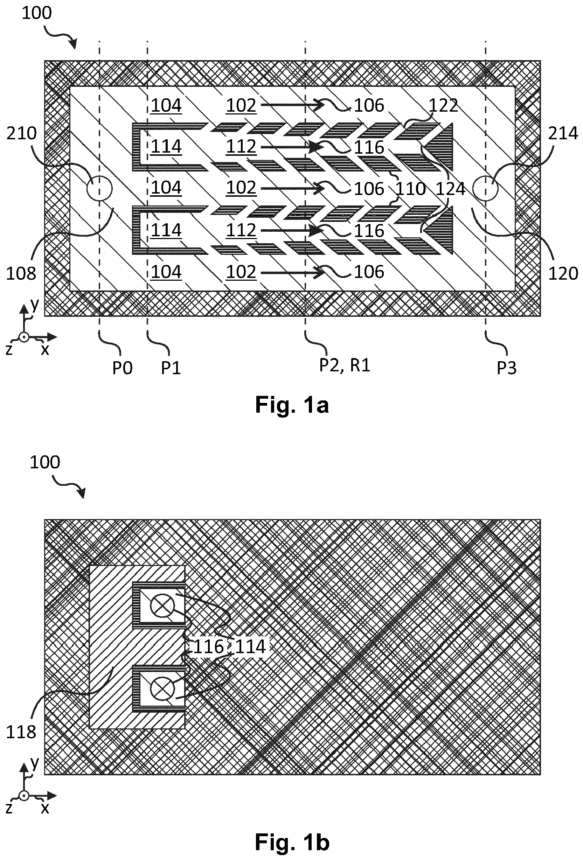

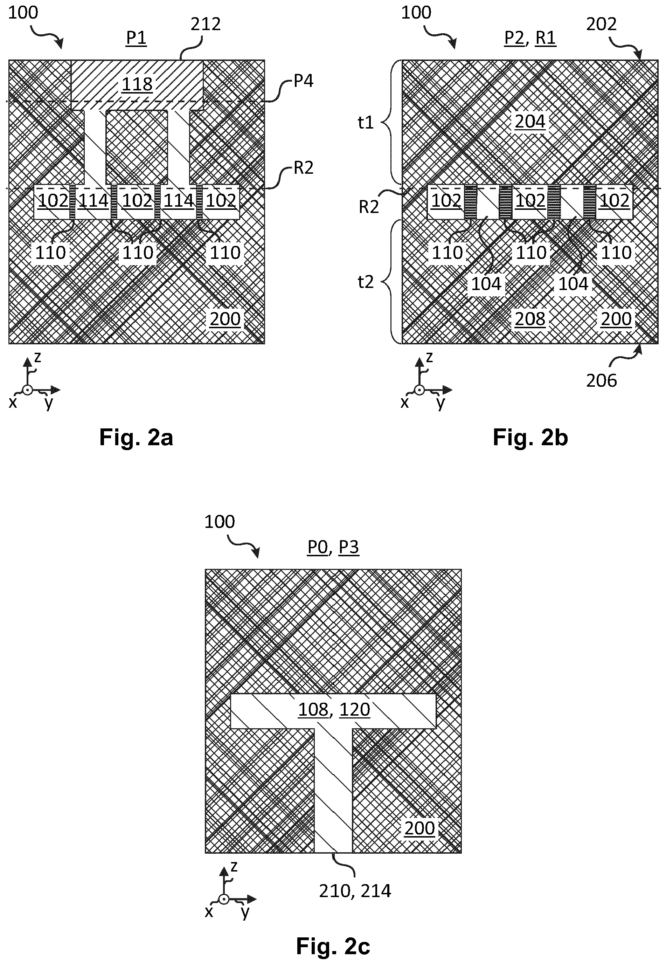

Fig. 1a, Fig. 1b, Fig. 2a, Fig. 2b, Fig. 2c give a schematic illustration of a heat sink 100 according to an embodiment.

Fig. 1a and Fig. 1b show sectional views of the heat sink 100 according to cuts parallel to the x-y (horizontal)-plane. The x-y-plane defining the view of Fig. 1a intersects the heat sink 100 approximately at its center along the z (vertical) direction, e. g. at the height of plane R2 in Fig. 2a, Fig. 2b; Fig. 1a shows a view top-down into the heat sink 100 cut in half along this plane. The x-y-plane defining the view of Fig. 1b intersects the heat sink 100 at a position further up along the z (vertical) direction, e. g. at the height of plane P4 in Fig. 2a; Fig. 1b shows a view top-down into the heat sink 100 cut along this plane.

Fig. 2a, Fig. 2b, and Fig. 2c show sectional views of the heat sink 100 parallel to the y-z (vertical)-plane, according to the planes Pi, P2 (R1), and Po, P3 indicated in Fig. 1a.

As is shown in Fig. 1a, the heat sink 100 encloses, in a fluid tight manner, an internal cavity with two types of coolant channels 102, 112, i. e. first coolant channels 102 and second coolant channels 112. The coolant channels 102, 112 extend from respective inflow sections 104, 114 to a common outflow section 120.

The inflow sections 104 of the first coolant channels 102 are fluid-connected to each other, namely by a distribution section 108 of the heat sink 100. Through a first coolant inlet 210, a coolant such as water mixed with glycol is provided to the distribution section 108, and from there to the first inflow sections 104 of the first coolant channels 102, driving a first coolant flow 106 through the first coolant channels 102. Having passed through the first coolant channels 102, the first coolant flow 106 passes through the common outflow section 120 and exits the heat sink 100 through an outlet 214.

As illustrated in Fig. 2a, a coolant is similarly provided through a second coolant inlet 212 and a second distribution section 118 to second inflow sections 114 of the second coolant channels 112. This drives a second coolant flow 116 (see Fig. 1a) through the second coolant channels 112.

As is illustrated in Fig. 1a, Ends 124 of the second coolant channels 112 are closed, such that the entire second coolant flow 116 passes through transverse channels 122 formed in common channel walls 110 of the first coolant channels 102 and the second coolant channels 112. The transverse channels 122 into the first coolant channels 102, or into the first coolant flow 106 therein, respectively, and ultimately into the common outflow section 120.

Consequently, the transverse channels 122 deflect part of the coolant flows 106, 116 from the direction x of the coolant channels 102, 112, which is parallel to the surfaces of the common channel walls 110. The transverse channels 112 thus drive part of the coolant flows 106, 116 towards/away from the common channel walls 110. In other words, they induce a component of the coolant flows 106, 116 perpendicular to the common channel walls 110. The transverse channels 122 thus break up the thermal resistance layer, which would otherwise form along the common channel walls 110, i. e. along their inner faces with respect to (and defining) the first coolant channels 102 and the second coolant channels 112. The transverse channels 122 thus improve the heat transfer between the heat sink 100 and the coolant, and improve the transfer of waste heat away from the heat sink 100 into the coolant channels 102, 112 and the coolant.

The provision of the spatially separate, fluid-separated distribution sections 108, 118 permits supplying them individually with suitable coolant pressures and/or coolant flows, to ensure a sufficient coolant flow through the transverse channels 122 to reliably break apart the thermal resistance layer. Preferentially, the coolant flow through the first distribution section 108 (and through the first inlet 210, respectively) is of a similar magnitude as the coolant flow through the second distribution section 118 (and the second inlet 212, respectively).

The reference plane R1 and the second reference plane R2 intersect the coolant channels 102, 112. The reference plane R1 is vertical and perpendicular to the coolant channels 102, 112. The second reference plane R2 is horizontal, and follows (i. e., comprises) the directions of the coolant channels 102, 112. All coolant channels 102, 112 are arranged in this second reference plane R2, i. e. they are intersected by the second reference plane R2.

Fig. 2a, Fig. 2b, and Fig. 2c further illustrate a heat sink body 200 of the heat sink 100.

The heat sink body 200 has a cuboid shape, with flat, horizontal cooling surfaces 202, 206 at its top and at its bottom. The coolant channels 102, 112 extend through the heat sink body 200 along a horizontal plane. Along the vertical direction the coolant channels 102, 112 are arranged in the heat sink body 200 halfway in between the cooling surfaces 202, 206.

A heat conducting material 204, 208 such as copper or aluminum couples the coolant channels 102, 112 thermally to the cooling surfaces 202, 206. The thickness ti, t2 of the heat conducting material 204, 208 is 10 mm. For smaller thicknesses ti, t2, such as below 4 mm, the heat transport away from the cooling surfaces 202, 206 and hence the temperature of the cooling surfaces 202, 206 may become inhomogeneous along the x-y-plane of the cooling surfaces 202, 206. For larger thicknesses ti, t2, such as more than 12 mm, the thermal coupling of the coolant channels 102, 112 to the cooling surfaces 202, 206 may become inefficient.

The heat sink 100 of Fig. 1a, Fig. 1b, Fig. 2a, Fig. 2b, and Fig. 2c is produced using additive or subtractive manufacturing techniques.

When a subtractive manufacturing technique is applied, an upper half-piece and a lower half-piece, each with a cuboid shape and a height corresponding to approximately half the height of the heat sink 100 are initially machined separately. The structures depicted in Fig. 1a and the inlets/outlets depicted in Fig. 2c are milled into the lower half-piece. The structure depicted in Fig. 1b and the second inlet 212 depicted in Fig. 2a are milled into the upper half-piece. To ensure that the coolant channels 102, 112 are arranged centered along the z direction in the final heat sink 100, the thicknesses of the half pieces may be slightly different from one another to compensate for the height of the coolant channels 102, 112. The half pieces are then connected in a fluid-tight manner, e.g. by vacuum welding or by a screw connection with a gasket in between the half-pieces, surrounding the cavity with the coolant channels 102, 112 in the plane defining the view of Fig. 1a.

When an additive manufacturing technique is applied, the heat sink 100 may be 3d-printed bottom-up with the structure depicted in Fig. 1a, Fig. 1b, Fig. 2a, Fig. 2b, and Fig. 2c. Alternatively, the two half-pieces described in the context of the subtractive fabrication may be formed by molding and then connected as described in the context of the subtractive fabrication.

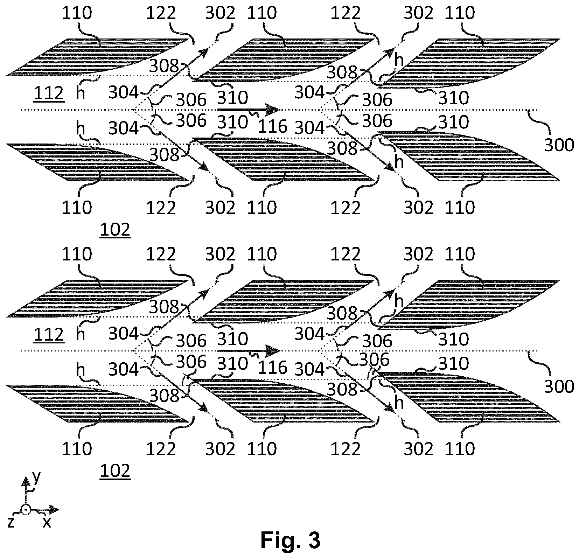

Fig. 3 gives a detailed view of the first coolant channels 102 and the second coolant channels 112.

The second coolant channels 112 have an extension direction 300. This direction 300 coincides with the main direction of the second coolant flow 116.

At each transverse channel 122, a portion 304 of the second coolant flow 116 gets deflected from the main direction 300 of the second coolant flow 116 and follows a direction 302 of the transverse channel 122. In the transverse channels 122, the direction 302 of the flow 304 hence coincides with the direction 302 of the transverse channel 122. Therefore, the flow 304 is also referred to as a transverse flow 304. The transverse flow 304 has a component towards (as seen from the second coolant channels 112) or away from (as seen from the first coolant channels 102) the common channel walls 110, or perpendicular to the common channel walls 110, respectively.

The direction 302 of the flow 304, or of the transverse channels 122, respectively, forms an acute angle 306 with respect to the direction 300 of the second coolant channels 112, or of the main direction of the second coolant flow 116, respectively.

In the depicted embodiment, the cross-sectional areas, or the widths, or the diameters, respectively, of the second coolant channels 112 decrease as the second coolant channels 112 extend away from the second inflow sections 114 (and towards the ends 124, see Fig. 1a). This ensures a higher pressure in the second coolant channels 112 than in the first coolant channels 102 along their length(s), and thus a flow through the transverse channels 122 from the second coolant channels 112 to the first coolant channels 102.

In alternative embodiments (not shown), the cross-sectional areas, or the widths, or the diameters, respectively, of the transverse channels 122 along the direction 300 of the second coolant channels 112 changes as the second coolant channels 112 extend away from the second inflow sections 114. In other words, transverse channels 122 further away from the second inflow sections 114 have cross sectional areas (or widths, or diameters, respectively) different from the ones of transverse channels 122 closer to the second inflow sections 114. This has a similar effect as the decreasing of cross-sectional areas (or widths, or diameters, respectively) of the second coolant channels 112 described above, i.e. to ensure a higher pressure in the second coolant channels 112 than in the first coolant channels 102 along their length(s). In embodiments with the changing cross-sectional areas (or widths, or diameters, respectively) of the transverse channels 122, the cross-sectional areas (or widths, or diameters, respectively) of the second coolant channels 112 may be constant along the direction 300. Alternatively, both the cross-sectional areas (or the widths, or the diameters, respectively) of the second coolant channels 112 may decrease and the cross-sectional areas (or the widths, or the diameters, respectively) of the transverse channels 122 may change along the direction 300.

The flow 304 is further guided into the transverse channels 122 by the guiding faces 308. The guiding faces 308 are arranged in the proximity of the transverse channels 122 downstream from the transverse channels 122. The guiding faces 308 extend into the second coolant channels 112, at acute angles 306 with respect to the direction 300 of the second coolant channels 112, and at acute angles 306 with respect to sections of the common channel walls 110 in between the transverse channels 122. In the depicted embodiment, the acute angles 306 are defined between the guiding faces 308 and the average position h of the upstream sections of the common channel walls 110.

The guiding faces 308 ensure a flow through the transverse channels 122 from the second coolant channels 112 to the first coolant channels 102, i.e., that the second coolant flows 116 get guided into the first coolant flows 106, even if a pressure difference between the coolant in the first coolant channels 102 and the second coolant channels 112 is small.

The guiding faces 308 are formed on protrusions 310. The protrusions 310 extend into the second coolant channels 112 from the common channel walls 110, more specifically from sections of the common channel walls 110 in between the transverse channels 122. The protrusions 310 extend deeper into the second coolant channels 112 than sections of the common channel walls 110 upstream from the respective transverse channel 122. In other words, the protrusions 310 extend into the second coolant channels 112 beyond the average positions h of the upstream sections of the common channel walls 110.

In addition to providing the guiding faces 308, with the advantages laid out above, the guiding faces 308 ensure the decreasing of cross-sectional areas (or widths, or diameters, respectively) of the second coolant channels 112 described above.

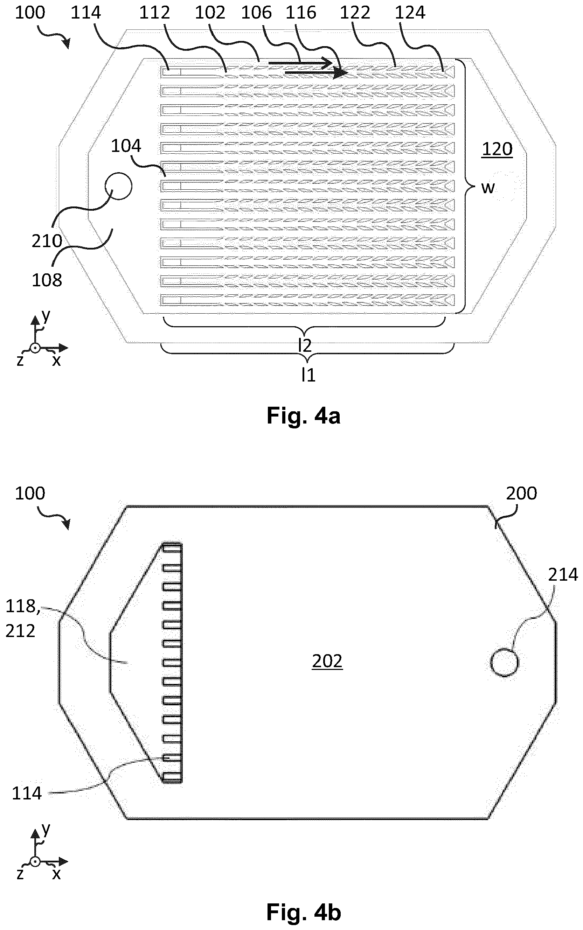

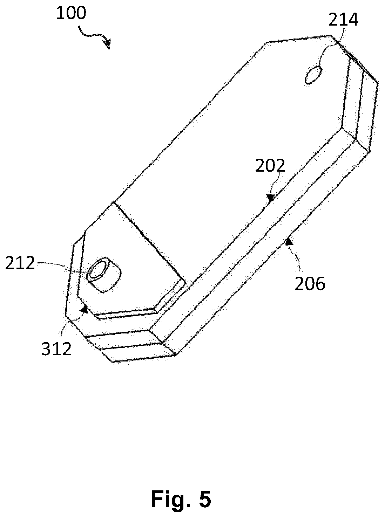

Fig. 4a, Fig. 4b, and Fig. 5 illustrate a heat sink 100 according to a second embodiment. The embodiment is similar to the one described in the context of Fig. 1a, Fig. 1b, Fig. 2a, Fig. 2b, and Fig. 2c, and same reference numerals refer to similar elements.

The embodiment of Fig. 4a, Fig. 4b, and Fig. 5 is dimensioned for an application in power electronics, semiconductor electronics, or optoelectronics such as laser diodes.

Fig. 4a and Fig. 4b show views corresponding to the ones of Fig. 1a and Fig. 1b, respectively. Fig. 5 gives a perspective view of the heat sink 100 according to the embodiment of Fig. 4a and Fig. 4b.

As shown in Fig. 5, the heat sink 100 comprises two planar cooling surfaces 202, 206 arranged on opposite sides of the heat sink 100. The cooling surfaces 202, 206 have extensions of 100 mm (along the x direction) × 140 mm (along the y direction).

As shown in Fig. 4a, the width w covered by the first coolant channels 102 and the second coolant channels 112 amounts to 114 mm. The lengths l1, l2 of the first coolant channels 102 and the second coolant channels 112 are each approximately 100 mm.

Further referring to Fig. 4a, the heat sink 100 comprises 14 first coolant channels 102 and 13 second coolant channels 112.

The protrusions 308 (see Fig. 3, not indicated in Fig. 4a, Fig. 4b, and Fig. 5) along the direction of the second flow 116 (or along the direction of the directions 300 of the second channels 102, respectively, see Fig. 3) consecutively protrude 0.2 mm into the second coolant channels 112. In other words, along the direction of the second flow 116 (or of the direction 300 of the second channel 112, respectively) a subsequent protrusion 308 protrudes 0.2 mm deeper into the second coolant channel 112 than a previous protrusion 308. The sections of the common channel walls 110 separating the transverse channels 122 from each other have lengths of 1.2 mm.

The angle between the direction 302 of the transverse channels 122 and the direction 300 of the first coolant channels 102 or of the second coolant channels 112 is 45°.

The height of the first coolant channels 102 and of the second coolant channels 112 along the z direction is 4 mm. The thickness ti, t2 of the heat conducting material 204, 208 is 10 mm.

As depicted in Fig. 5, the heat sink 100 comprises an inlet element 312 comprising the second coolant inlet 212.

In the embodiment depicted in Fig. 4a, Fig. 4b, and Fig. 5, the second coolant inlet 212 and the outlet 214 are both formed on the top surface of the heat sink 100, and the first coolant inlet 210 is formed on the bottom surface. In alternative embodiments (not shown), any of the coolant inlets 210, 212 and/or the outlet 214 is formed on any of the two surfaces, depending on the requirements of the specific application. In particular, the coolant inlets 210, 212 and the outlet 214 can be formed on the same surface to leave the other surface free from coolant inlets or outlets. Alternatively, any of the coolant inlets 210, 212 and/or the outlet 214 may be formed on both surfaces, for example the outlet 214 may be formed on the bottom surface and on the top surface.

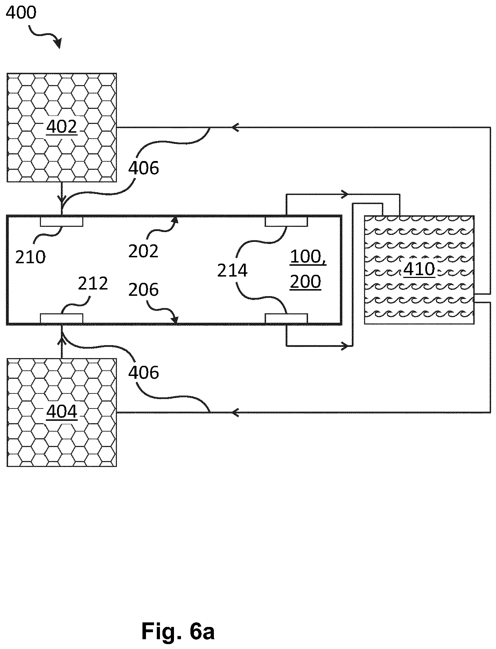

Fig. 6a shows a heat sink system 400 according to a first embodiment.

The heat sink system 400 comprises a first pump 402 with fluid connections 406 to the first coolant inlet 210 and the outlet 214, to drive the first coolant flow 106 through the first coolant channels 102.

The heat sink system 400 comprises a second pump 404 with fluid connections 406 to the second coolant inlet 212 and the outlet 214, to drive the second coolant flow 116 through the second coolant channels 112.

The heat sink system 400 permits to control the coolant flows 106, 116 through the first coolant channels 102 and the second coolant channels 112 independently of each other, in terms of their relative and absolute values.

The heat sink system 400 also permits to control the pressures at the first distribution section 108 and at the second distribution section 118 independently of each other, in terms of their relative and absolute values.

The heat sink system 400 also comprises a coolant reservoir 410 in line with the heat sink 100 and each of the pumps 402, 404 of the heat sink system 400, to provide the coolant to the heat sink system 400 in a sufficient amount. The coolant reservoir 410 facilitates quick and easy diagnosis (e.g., through a viewport of the coolant reservoir 410) and control/refill of a coolant level of the heat sink system 400.

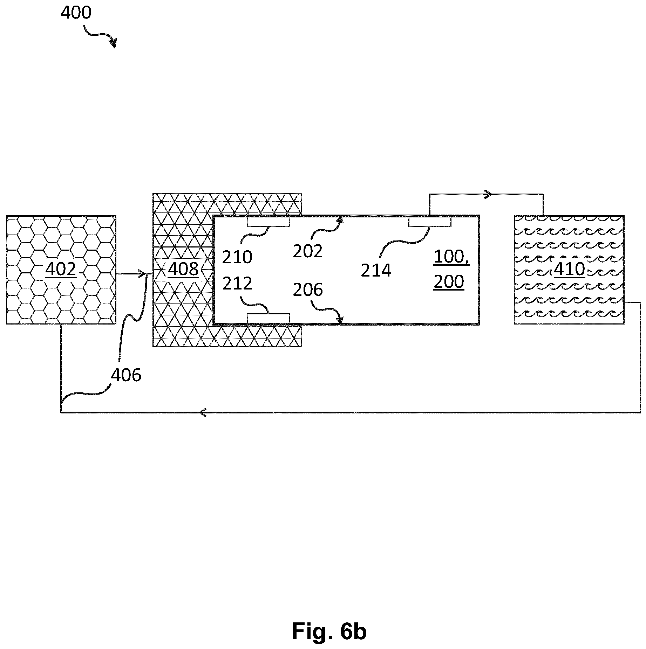

Fig. 6b shows a heat sink system 400 according to a second embodiment.

The heat sink system 400 comprises a first pump 402 with fluid connections 406 to a coolant throughput divider 408 and to the outlet 214.

The coolant throughput divider 408 is further fluid-connected to the first coolant inlet 210 and to the second coolant inlet 212.

The heat sink system 400 forms a first coolant cycle through the first pump 402, the coolant throughput divider 408, the first coolant inlet 210, and the outlet 214.

The heat sink system 400 forms a second coolant cycle through the first pump 402, the coolant throughput divider 408, the second coolant inlet 212, and the outlet 214.

Consequently, the first pump 402 and the coolant throughput divider 408 drive the coolant flows 106, 116 through the respective coolant channels 102, 112.

The coolant throughput divider 408 provides a means to control the relative coolant throughputs through the first distribution section 108 (and/or through the first coolant inlet 210, respectively) and through the second distribution section 118 (and/or through the second coolant inlet 212, respectively). Alternatively, the coolant throughput divider 408 provides a means to control the coolant pressure at the first distribution section 108 (and/or at the first coolant inlet 210, respectively) and at the second distribution section 118 (and/or at the second coolant inlet 212, respectively). In one embodiment (not depicted), the coolant throughput divider 408 is implemented as a T-shaped or Y-shaped fluid junction, with different flow resistances (e.g., different diameters) of the two branches of the T or the Y. In another embodiment (not depicted), the coolant throughput divider 408 is also implemented as a T-shaped or Y-shaped fluid junction, and a flow valve is introduced in at least one of the branches of the T or the Y, and permits to control the flow resistance of the respective branch.

In some embodiments (not depicted), the coolant throughput divider 408 is physically comprised in the heat sink 100, for example in the heat sink body 200. In alternative embodiments (not depicted), the coolant throughput divider 408 is movable relative to the heat sink 100, which may improve the design flexibility of the heat sink system 400. In corresponding embodiments (not depicted), a single pump 402 and/or a single coolant throughput divider 408 maybe provided for several heat sinks 100.

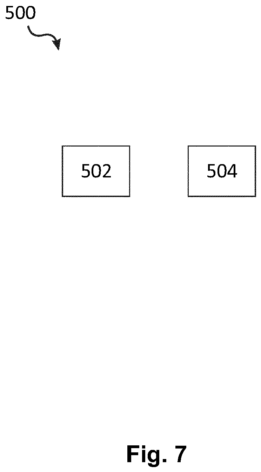

Fig. 7 illustrates a method 500 for operating a heat sink 100 as described above.

At step 502, the method 500 comprises adjusting a first coolant throughput through the first distribution section 108.

At step 504, the method 500 comprises adjusting a second coolant throughput through the second distribution section 118 to guide at least a portion of the second coolant flows 116 through the transverse channels 122 into the first coolant flows 106.

Preferably, the method 500 also comprises adjusting the second coolant throughput independent of the first coolant throughput; and/or adjusting a first coolant pressure at the first distribution section 108 to a value different from a second coolant pressure at the second distribution section 118, e. g. as described in the context of Fig. 6a and Fig. 6b.

### LIST OF REFERENCE SIGNS

- 100: heat sink
- 102: first coolant channels
- 104: first inflow sections
- 106: first coolant flows
- 108: first distribution section
- 110: common channel walls
- 112: second coolant channels
- 114: second inflow sections
- 116: second coolant flows
- 118: second distribution section
- 120: common outflow section
- 122: transverse channels
- 124: ends of the second coolant channels opposite to the first inflow sections
- P0, Pi, P2, P3: planes; y-z-planes
- R1: reference plane; y-z-plane
- R2: second reference plane; x-y-plane
- 200: heat sink body
- 202: cooling surface
- 204, 208: heat conducting material
- 206: second cooling surface
- ti, t2: thickness of heat conducting material
- 210: first coolant inlet
- 212: second coolant inlet
- 214: outlet
- 300: directions of second cooling channels
- 302: directions of transverse channels
- 304: flows guided by the transverse channels
- 306: acute angles
- 308: guiding faces
- 310: protrusions from inner faces of the second coolant channels
- h: reference lines reflecting inner faces of the second coolant channels without protrusions
- l1, l2: lengths the first, second coolant channels
- w: width of channel region
- 312: inlet element
- 400: heat sink system
- 402: first pump
- 404: second pump
- 406: coolant line
- 408: coolant throughput divider
- 410: coolant reservoir
- 500: method
- 502: adjusting a first coolant throughput through the first distribution section
- 504: adjusting a second coolant throughput through the second distribution section

## Claims

1. A heat sink (100), comprising
first coolant channels (102), wherein the first coolant channels (102) comprise first inflow sections (104) and are adapted to guide first coolant flows (106),
a first distribution section (108), providing a fluid connection between the first inflow sections (104),
second coolant channels (112), wherein the second coolant channels (112) comprise second inflow sections (114) and are adapted to guide second coolant flows (116),
a second distribution section (118), providing a fluid connection between the second inflow sections (114),
a common outflow section (120) for the first coolant flows (106) and the second coolant flows (116), and
transverse channels (122) between the first coolant channels (102) and the second coolant channels (112) to guide at least a portion of the second coolant flows (116) into the first coolant flows (106).

2. The heat sink (100) of claim 1,
comprising an alternating arrangement of the first coolant channels (102) and the second coolant channels (112), and/or
comprising common channel walls (110) of the first coolant channels (102) and the second coolant channels (112).

3. The heat sink (100) of claim 1 or 2, wherein
directions of the first coolant channels (102) are parallel to each other, and/or
directions (300) of the second coolant channels (112) are parallel to each other, and/or
directions of the first coolant channels (102) are parallel to directions (300) of the second coolant channels (112), and/or
a reference plane (Ri) perpendicular to at least one of the first coolant channels (102) and/or perpendicular to at least one of the second coolant channels (112) intersects the first coolant channels (102) and the second coolant channels (112).

4. The heat sink (100) of any of the preceding claims, which further comprises
a first coolant inlet (210) and a first fluid connection between the first coolant inlet (210) and the first distribution section (108) to supply the first coolant flows (106) to the first coolant channels (102),
a second coolant inlet (212) and a second fluid connection between the second coolant inlet (212) and the second distribution section (118) to supply the second coolant flows (116) to the second coolant channels (112), and
a heat sink body (200), wherein the first coolant inlet (210) and the second coolant inlet (212) are arranged spaced apart from each other on the heat sink body (200).

5. The heat sink (100) of any of the preceding claims,
wherein directions (302) of the transverse channels (122) are inclined with respect to the directions (300) of the second coolant channels (112), or
wherein the directions (302) of the transverse channels (122) are inclined with respect to directions (300) of the second coolant channels (112) at acute angles (306).

6. The heat sink (100) of any of the preceding claims, wherein widths of the transverse channels (122) are smaller than widths of the first coolant channels (102) and/or than widths of the second coolant channels (112), and/or
wherein the transverse channels (122) are adapted to gradually guide the at least a portion of the second coolant flows (116) into the first coolant flows (106).

7. The heat sink (100) of any of the preceding claims,
wherein the transverse channels (122) are adapted to guide the entire second coolant flows (116) into the first coolant flows (106), and/or
wherein ends (124) of the second coolant channels opposite to the first inflow sections (114) are closed, and/or
wherein, along the directions of the second coolant channels (112), the second coolant channels (112) are closed at both ends.

8. The heat sink (100) of any of the preceding claims, further comprising guiding faces (308) in the second coolant channels (112) adapted to guide the at least a portion of the second coolant flows (116) to and/or into the transverse channels (122).

9. The heat sink (100) of claim 8,
wherein the guiding faces (308) extend into the second coolant channels (112), and/or
wherein the guiding faces (308) are inclined with respect to directions (300) of the second coolant channels (112), or
wherein the guiding faces (308) are inclined with respect to the directions (300) of the second coolant channels (112) at acute angles (306).

10. The heat sink (100) of claim 8 or 9, further comprising protrusions (310) from the inner faces of the second coolant channels (112), wherein the guiding faces (308) are arranged on the protrusions (310).

11. The heat sink (100) of any of the preceding claims,
wherein the first coolant channels (102) provide Reynolds numbers between 3000 and 5000, and/or
wherein the second coolant channels (112) provide Reynolds numbers between 3000 and 5000.

12. The heat sink (100) of any of the preceding claims,
wherein a total flow resist of the second coolant channels (112) exceeds a total flow resist of the first coolant channels (102), and/or
wherein cross-sectional areas of the second coolant channels (112) decrease as the second coolant channels (112) extend away from the second inflow sections (114).

13. The heat sink (100) of any of the preceding claims, which further comprises a cooling surface (202, 206), and
wherein at least sections of the first coolant channels (102) extend in parallel to the cooling surface (202, 206), and/or
wherein at least sections of the second coolant channels (112) extend in parallel to the cooling surface (202, 206), and/or
wherein the heatsink (100) comprises a heat conducting material (204, 208) arranged between the cooling surface (202, 206) and the first coolant channels (102) and/or the second coolant channels (112), wherein a thickness (ti, t2) of the heat conducting material (204, 208) between the cooling surface (202, 206) and the first coolant channels (102) and/or the second coolant channels (112) is at least 4 mm or at least 6 mm or at least 7 mm or at least 8 mm.

14. A method (500) for operating a heat sink (100), wherein the heat sink (100) comprises:
first coolant channels (102), wherein the first coolant channels (102) comprise first inflow sections (104) and are adapted to guide first coolant flows (106),
a first distribution section (108), providing a fluid connection between the first inflow sections (104),
second coolant channels (112), wherein the second coolant channels (112) comprise second inflow sections (114) and are adapted to guide second coolant flows (116),
a second distribution section (118), providing a fluid connection between the second inflow sections (114),
a common outflow section (120) for the first coolant flows (106) and the second coolant flows (116), and
transverse channels (122) between the first coolant channels (102) and the second coolant channels (112);
the method comprising:
adjusting (502) a first coolant throughput through the first distribution section (108), and
adjusting (504) a second coolant throughput through the second distribution section (118) to guide at least a portion of the second coolant flows (116) through the transverse channels (122) into the first coolant flows (106).

15. The method (500) of claim 14, which comprises
adjusting the second coolant throughput independently of the first coolant throughput; and/or
adjusting a first coolant pressure at the first distribution section (108) to a value different from a second coolant pressure at the second distribution section (118).
